Europäisches Patentamt

European Patent Office

Office européen des brevets

(11) Numéro de publication: **0 040 155**

**A1**

# (12) DEMANDE DE BREVET EUROPEEN

(21) Numéro de dépôt: **81400747.2**

(22) Date de dépôt: **11.05.81**

(51) Int. Cl.³: **H 03 K 17/95**
**H 03 K 17/945**

(30) Priorité: **12.05.80 FR 8010689**

(43) Date de publication de la demande:
**18.11.81 Bulletin 81/46**

(84) Etats contractants désignés:
**CH DE GB IT LI**

(71) Demandeur: **CROUZET**
**128, Avenue de la République**
**F-75011 Paris(FR)**

(72) Inventeur: **Astic, Georges**
**"L'Oasis" Quartier de l'Etrau**
**F-26320 Saint Marcel les Valence(FR)**

(74) Mandataire: **Bloch, Robert et al,**
**39 avenue de Friedland**
**F-75008 Paris(FR)**

(54) **Perfectionnements aux détecteurs de proximité statiques.**

(57) L'invention concerne un détecteur de pièce métallique dont la présence est détectée dans un champ magnétique engendré par un circuit (100). Ce circuit (100) commande un récepteur (R), indiquant la présence d'une pièce, par une série de transistors (201, 203, 207) et par un dispositif de sectionnement (30), permettant de transformer le détecteur par action simple, en un détecteur soit du type à fermeture soit du type à ouverture. L'invention améliore les conditions de stockage.

EP 0 040 155 A1

## Perfectionnements aux détecteurs de proximité statiques.

La présente invention concerne un détecteur de proximité statique, notamment pour pièces métalliques, comprenant une enveloppe/un premier circuit électronique agencé pour engendrer un champ magnétique et détecter la présence dans le champ d'un objet, et un second circuit électronique, connecté au premier, pour commander un récepteur électrique indiquant la présence de l'objet dans le champ.

Dans les détecteurs de proximité statiques connus, et notamment dans ceux du type inductif, le circuit de détection comporte généralement un élément capteur électromagnétique – un circuit oscillant dont la bobine est enroulée sur un noyau magnétique ouvert –, dont le régime oscillatoire est fortement perturbé par l'introduction d'une pièce métallique dans son champ de rayonnement.

Le signal binaire issu du circuit de détection ainsi perturbé est appliqué à un circuit d'utilisation destiné à commander l'alimentation électrique d'un récepteur.

Ce circuit d'utilisation comporte généralement au moins un transistor dont l'état normal de conduction, ou de blocage, est déterminé par l'état du signal issu du circuit de détection, qui dépend de la présence, ou non, d'une pièce dans le champ du capteur.

C'est-à-dire que dans le cadre d'une production en série organisée pour satisfaire, à la demande, l'ensemble des besoins des utilisateurs, on est nécessairement amené à prévoir la fabrication de détecteurs soit du type à ouverture, soit du type à fermeture, le récepteur du détecteur, par exemple à fermeture, étant alimenté lorsqu'une pièce est présente dans le champ de détection du capteur.

Etant donné que pratiquement tous les détecteurs de proximité sont des produits non modifiables, une fois scellés dans leur enveloppe, il est indispensable, par précaution, de fabriquer et de stocker des détecteurs de deux modèles distincts, en pouvant difficilement prévoir celui sur lequel va porter la demande des clients.

Ces derniers d'ailleurs, parmi lesquels les distributeurs contraints d'avoir des stocks très faibles, n'apprécient pas leur doublement en deux modèles distincts.

Ainsi, la présente invention a pour but de remédier à cet inconvénient et de procurer à l'utilisateur la faculté d'effectuer si besoin est, grâce à une action très simple exercée sur place au moment de la mise en service, la transformation par exemple d'un modèle de détecteur "à fermeture" en un modèle "à ouverture".

Afin d'atteindre ce but, la présente invention concerne un détecteur de proximité statique, notamment pour pièces métalliques, comprenant une enveloppe contenant un premier circuit électronique agencé pour engendrer un champ magnétique et détecter la présence dans le champ d'un objet, et un second circuit électronique, connecté au premier, pour commander un récepteur électrique indiquant la présence de l'objet dans le champ, caractérisé par le fait que le second circuit de commande du récepteur d'indication comporte un premier interrupteur, connecté à la sortie du premier circuit de détection, un second interrupteur, des moyens connectés entre la sortie du circuit de détection et le second interrupteur, de sorte que les deux interrupteurs soient l'un ouvert et l'autre fermé, un troisième interrupteur, normalement dans le même état que le premier interrupteur, et connecté entre le premier interrupteur et le récepteur, des moyens agencés pour ouvrir le troisième interrupteur, des moyens agencés pour connecter le deuxième interrupteur et le récepteur, et des moyens agencés pour détruire simultanément les moyens d'ouverture et les moyens de connexion.

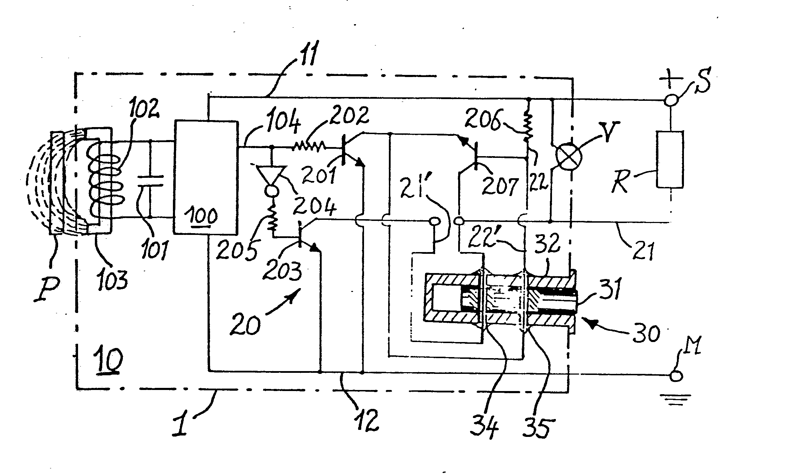

Les caractéristiques et avantages de l'invention ressortiront plus clairement de la description qui suit d'une forme de réalisation donnée à titre d'exemple, en se référant au dessin annexé, dans lequel la figure unique illustre schématiquement l'organisation fonctionnelle interne du détecteur de proximité du type inductif de l'invention.

Le dispositif représenté sur la figure est un détecteur de proximité du type inductif, dont l'ensemble 10 des composants technologiques est enfermé dans une enveloppe 1, que l'on remplit par exemple de résine isolante polymérisable après l'assemblage final.

L'ensemble 10 du dispositif détecteur comprend un circuit de détection 100, essentiellement constitué par un oscillateur, un circuit capteur, auquel le circuit de détection est adapté, et qui comporte, en parallèle, un condensateur 101 et une bobine 102 enroulée sur un noyau magnétique ouvert 103, formé par exemple d'un pot de ferrite douce.

L'énergie électrique nécessaire à l'entretien de l'oscillateur du cricuit de détection 100 est founie par une source d'alimentation S à tension continue, à travers des lignes 11 et 12 respectivement raccordées à la source S et à la masse M.

Lorsqu'on introduit dans le champ magnétique oscillant, rayonné à travers la paroi de l'enveloppe 1 par le circuit magnétique 103, une pièce métallique P, l'impédance du système oscillant est modifiée à un point tel que l'oscillation, entretenue en l'absence de pièce P, cesse brusquement par excès de charge et qu'un signal, sous forme d'une tension continue, apparaît simultanément sur la sortie 104 du circuit de détection 100 pour être appliquée à l'étage suivant du détecteur 10, constitué par un circuit d'utilisation, ou de commande, 20.

Ce circuit 20 est organisé pour permettre, en fonction de la présence ou de l'absence de la pièce P dans le champ oscillant du circuit de détection 100, la commande, à distance, d'un récepteur électrique R, relié à la source S et au circuit d'utilisation 20 par une ligne 21.

Un voyant lumineux V est de préférence monté sur l'enveloppe 1 du détecteur 10 et branché entre les lignes 11 et 21, pour permettre la visualisation à distance de l'état d'alimentation du récepteur R.

Le circuit d'utilisation 20 comprend un premier transistor 201, comme premier interrupteur, dont la base est reliée, par l'intermédiaire d'une résistance 202, à la sortie 104 du circuit de détection 100, ainsi qu'un deuxième transistor 203, comme second interrupteur, dont la base est également reliée à la sortie 104, mais par l'intermédiaire d'un élément inverseur 204 en série avec une résistance 205. Les émetteurs des deux transistors sont l'un et l'autre reliés à la masse M par la ligne 12. Lorsque le transistor 201 est passant, le transistor 203 est bloqué, et inversement. En d'autres termes, quand l'interrupteur 201 est fermé, l'interrupteur 203 est ouvert, et inversement.

En outre, les collecteurs des transistors 201 et 203 sont l'un et l'autre reliés à la source d'alimentation S respectivement à travers une résistance 206 et le récepteur R, grâce à des lignes intermédiaires de connexion 22' et 21', respectivement, dont le rôle et le montage particuliers seront exposés plus loin.

Enfin, le circuit d'utilisation 20 comprend un troisième transistor 207, comme troisième interrupteur, du même type que les transistors 201 et 203, dont la base et le collecteur sont respectivement reliés à la source S, par une ligne 22, à travers la résistance 206, et au récepteur R, par la ligne 21, l'émetteur du transistor 207 étant relié au collecteur du transistor 201, et à sa propre base par la ligne 22', qui isole donc ce transistor 207. Ce troisième interrupteur est donc connecté entre le premier interrupteur 201 et le récepteur R et devrait se trouver normalement dans le même état que le premier interrupteur 201.

Tel qu'on vient d'en décrire l'agencement, le détecteur 10 est du type dit "à fermeture" correspondant à une alimentation du récepteur R lorsque la pièce P est présente dans le champ du circuit de détection 100.

Dans ces conditions, en effet, lorsqu'aucune tension n'est présente à la sortie 104 du détecteur 100, du fait du décrochement du système oscillant, le transistor 201 est bloqué, alors qu'au contraire, à cause de la présence de l'inverseur 204, le transistor 203 est passant, entraînant l'alimentation du récepteur R et l'allumage du voyant V depuis la source S jusqu'à la masse M par l'intermédiaire des lignes 21 et 21'.

A l'inverse, lorsque la pièce P sort du champ du circuit de détection 100, la tension à la sortie 104 apparaît, le transistor 203 est alors bloqué, le transistor 201 est, lui, passant mais comme le transistor 207, en série avec le transistor 201, demeure bloqué du fait de sa neutralisation par la liaison, par la ligne 22', entre sa base et son émmetteur, c'est-à-dire que ce troisième interrupteur 207, bien que le premier 201 soit fermé, reste ouvert grâce à la ligne 22', le récepteur R n'est plus alimenté et le voyant V s'éteint.

Si maintenant, l'utilisateur du détecteur 10 que l'on vient de décrire désire le transformer en un type dit "à ouverture", pour satisfaire immédiatement les besoins de son installation, il n'aura simplement qu'à couper ou détruire les lignes de connexion 21' et d'ouverture 22', grâce à un dispositif de sectionnement 30, sur lequel il peut agir au moment voulu depuis l'extérieur de l'enveloppe 1.

En effet, dès lors que les connexions, initialement établies par les lignes 21' et 22' sont interrompues, le détecteur 10 est transformé en un type dit "à ouverture" correspondant à un arrêt de l'alimentation du récepteur R lorsque la pièce P est présente dans le champ du cricuit de détection 100.

Dans ces nouvelles conditions, mais tout comme dans le cas précédent, et pour la même raison, il n'y a pas de tension à la sortie 104 du circuit——————————de détection 100; le transistor 201 est donc toujours bloqué, mais le transistor 203, bien qu'à l'état passant est rendu inopérant du fait de l'interruption de la ligne de connexion 21'.

A l'inverse, lorsque la pièce P sort du champ du circuit de détection 100, entraînant l'apparition d'une tension à la sortie 104, et le déblocage du transistor 201 en série avecle transistor 207 débloqué par la résistance 206, du fait qu'il est rendu à son état passant par la coupure de la ligne 22', la liaison avec la masse est établie, et l'alimentation du récepteur R est alors réalisée et le voyant V s'allume.

Le dispositif de sectionnement 30 des lignes 21' et 22' comprend avantageusement, et de préférence, une tige 31 coulissant juste et avec frottement dans un tube 32 s'étendant sur toute sa longueur à l'intérieur de l'enveloppe 1 du détecteur, et dont l'extrémité accessible de l'extérieur, éventuellement fermée par un opercule amovible, débouche au niveau d'une des parois extérieures de cette enveloppe 1.

L'ensemble 30, formé par le tube 32 et la tige 31, est réalisé en matière isolante, rigide ou flexible, et compor-

te deux trous séparés 34 et 35 le traversant diamétralement de part en part pour permettre, au moment du câblage final du détecteur, l'enfilage des lignes 21' et 22' dont l'âme conductrice est normalement prévue en métal relativement tendre, comme par exemple en fil de cuivre émaillé pour bobinage.

On conçoit ainsi aisément que, lorsqu'ayant décidé de modifier la fonction de base du détecteur, on exerce une poussée, ou éventuellement une traction, volontaire et avec un effort suffisant sur la tige coulissante 31, on provoque le cisaillement simultané des lignes 21' et 22' au niveau des trous 34 et 35 et des parois ajustées du tube 32 et de la tige 31. Naturellement, toutes dispositions doivent être prises pour éviter le blocage de la tige par pénétration de résine de remplissage dans le tube, notamment par les trous 34 et 35. Par contre, le positionnement, après sectionnement des lignes 21' et 22', est naturellement assuré par la présence de la résine de remplissage de l'enveloppe du détecteur.

Revendications

1.- Détecteur de proximité statique, notamment pour pièces métalliques, comprenant une enveloppe contenant un premier circuit électronique agencé pour engendrer un champ magnétique et détecter la présence dans le champ d'un objet, et un second circuit électronique, connecté au premier, pour commander un récepteur électrique indiquant la présence de l'objet dans le champ, caractérisé par le fait que le second circuit de commande du récepteur d'indication comporte un premier interrupteur (201), connecté à la sortie (104) du premier circuit de détection (100), un second interrupteur (203), des moyens (204) connectés entre la sortie (104) du circuit de détection (100) et le second interrupteur (203), de sorte que les deux interrupteurs (201, 203) soient l'un ouvert et l'autre fermé, un troisième interrupteur (207), normalement dans le même état que le premier interrupteur (201), et connecté entre le premier interrupteur (201) et le récepteur (R), des moyens (22') agencés pour ouvrir le troisième interrupteur (207), des moyens (21') agencés pour connecter le deuxième interrupteur (203) et le récepteur (R), et des moyens (30) agencés pour détruire simultanément les moyens d'ouverture (22') et les moyens de connexion (21').

2.- Détecteur selon la revendication 1, dans lequel les trois interrupteurs sont des transistors (201, 203, 207), la sortie (104) du circuit de détection (100) est connectée au second transistor (203) par un inverseur (204), et l'émetteur du troisième transistor (207) est connecté au collecteur du premier transistor (201).

3.- Détecteur selon la revendication 2, dans lequel la base et l'émetteur du troisième transistor (207) sont connectés par une première ligne (22') pouvant être coupée et le collecteur du second transistor (203) et le récepteur (R) sont connectés par une deuxième ligne (21') pouvant être coupée.

4.- Détecteur selon la revendication 3, dans lequel les lignes (22', 21') peuvent être coupées par des moyens de sectionnement (30).

5.- Détecteur selon la revendication 4, dans lequel les moyens de sectionnement (30) comprennent un tube (32) et une tige (31) agencée pour coulisser dans le tube (32), le tube (32) portant les lignes (22', 21') pouvant être coupées, et des trous (34, 35) étant ménagés dans la paroi du tube pour le passage des lignes (22', 21').

Office européen
des brevets

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendication concernée |
|---|---|---|
| | <u>CH - A - 488 279</u> (LANDIS & GYR)<br><br>* figure 2; de colonne 2, ligne 38 - colonne 3, ligne 24 *<br><br>--- | 1,2 |
| | <u>CH - A - 488 278</u> (ROBERT BOSCH)<br><br>* figure 1; colonne 3, lignes 30-55; colonne 4, lignes 10-22; colonne 5, lignes 18-23 *<br><br>& FR - A - 2 010 855<br><br>-- | 1,2 |
| | <u>FR - A - 2 302 502</u> (LA TELEMECA-NIQUE ELECTRIQUE)<br><br>* figure 3; de page 4, ligne 39 - page 5, ligne 14 *<br><br>-- | 1,2 |
| | COMPONENTS REPORT, vol. 9, no. 5, décembre 1974, Siemens A.G. MUNICH (DE)<br>A. HAUENSTEIN et al.:"Integrated Threshold Switch TCA 105"<br>pages 126-129<br><br>* figures 1,12; pages 126,129 *<br><br>-- | 1,2 |
| | RADIO FERNSEHEN ELEKTRONIK, vol. 26, no. 12, juin 1977<br>BERLIN (DD)<br>BUTTGEREIT: "Die integrierte Initiatorschaltung A 301 D"<br>pages 403-406<br><br>* figures 1,2; page 403 *<br><br>------ | 1,2 |

**CLASSEMENT DE LA DEMANDE (Int. Cl.³)**

H 03 K 17/95
17/945

**DOMAINES TECHNIQUES RECHERCHES (Int. Cl.³)**

H 03 K 17/95
17/945

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 07-08-1981 | LEDRUT |

OEB Form 1503.1 06.78